# EUROPÄISCHE PATENTSCHRIFT

(11) **EP 2 748 620 B1**
(45) Veröffentlichungstag und Bekanntmachung des Hinweises auf die Patenterteilung: **21.09.2016**
(21) Anmeldenummer: 12759663.3
(22) Anmeldetag: 23.08.2012
(51) Int. Cl.: G01R 27/10, G01R 27/14, H05B 3/84, G01R 27/20

(54) **ANORDNUNGEN UND VERFAHREN ZUR BESTIMMUNG DES KONTAKTWIDERSTANDS ELEKTRISCH LEITFÄHIGER SCHICHTEN**
ASSEMBLIES, METHOD AND SHEETS FOR DETERMINING THE CONTACT RESISTANCE OF ELECTRICALLY CONDUCTIVE LAYERS
AGENCEMENTS, PROCÉDÉS ET CORPS PLAT POUR LA DÉTERMINATION DE LA RÉSISTANCE DE CONTACT DE COUCHES CONDUCTRICES D'ÉLECTRICITÉ

(30) Priorität: 26.08.2011 EP 11179117
(43) Veröffentlichungstag der Anmeldung: 02.07.2014
(73) Patentinhaber: Saint-Gobain Glass France, 92400 Courbevoie (FR)
(72) Erfinder: REUL, Bernhard, 52134 Herzogenrath (DE); LISINSKI, Susanne, 50739 Köln (DE); SCHREIBER, Walter, 52074 Aachen (DE); LETOCART, Philippe, B-4730 Raeren (BE); SCHLARB, Andreas, 42287 Wuppertal (DE); SCHALL, Günther, 52372 Kreuzau (DE); LESMEISTER, Lothar, NL-6373 Landgraaf (NL); SCHMALBUCH, Klaus, 52074 Aachen (DE); WEBER, Patrick, 52477 Alsdorf (DE)
(74) Vertreter: Gebauer, Dieter Edmund
(86) Internationale Anmeldenummer: PCT/EP2012/066382
(87) Internationale Veröffentlichungsnummer: WO 2013/030070

(56) Entgegenhaltungen:
- DE-A1- 3 445 213
- DE-B1- 1 541 797
- US-A- 2 921 257
- US-B1- 6 323 661

## Beschreibung

Die Erfindung liegt auf dem technischen Gebiet der Herstellung von Flächenkörpern mit wenigstens einem Substrat, einer elektrisch leitfähigen Funktionsschicht und wenigstens einer Elektrodenschicht zur Kontaktierung der Funktionsschicht und betrifft Anordnungen und Verfahren zur Bestimmung des Kontaktwiderstands elektrisch leitfähiger Schichten.

### Stand der Technik

Beheizbare Verglasungen mit einer elektrischen Heizschicht sind als solche wohlbekannt und bereits vielfach in der Patentliteratur beschrieben worden. Lediglich beispielhaft sei in diesem Zusammenhang auf die deutschen Offenlegungsschriften DE 10 2008 018147 A1 und DE 10 2008 029986 A1 verwiesen. In Kraftfahrzeugen werden sie häufig als Windschutzscheiben eingesetzt, da das zentrale Sichtfeld im Unterschied zu Heckscheiben keine Sichteinschränkungen aufweisen darf.

In beheizbaren Verglasungen wird der Heizstrom typischer Weise durch bandförmige Sammelleiter bzw. Sammelschienen ("Bus Bars") in die elektrische Heizschicht eingeleitet, welche den Heizstrom möglichst gleichmäßig auf breiter Front verteilen sollen. Die Sammelleiter werden in der Regel auf die Heizschicht gedruckt, wobei es aber auch bekannt ist, dünne Metallfolienstreifen als Sammelleiter einzusetzen.

Dabei besteht das Problem, dass der elektrische Kontaktwiderstand der Sammelleiter relativ stark variieren kann, wobei ein geringer Kontaktwiderstand für eine bessere Kontaktqualität, ein hoher Kontaktwiderstand dementsprechend für eine schlechtere Kontaktqualität spricht. Bei einem hohen Kontaktwiderstand erwärmt sich der Kontaktbereich während des Betriebs relativ stark, so dass die Verlustleistung erhöht ist.

Bislang wird die Kontaktqualität der auf die Heizschicht gedruckten Sammelleiter indirekt durch Thermographie bestimmt, wodurch die übermäßige Erwärmung schlecht kontaktierter Sammelleiter erkennbar ist. Jedoch kann die thermographische Untersuchung erst am Ende des Herstellungsprozesses durchgeführt werden, da eine Bestromung ein fertiges Produkt erfordert. Ein Eingriff während des Herstellungsprozesses ist nicht möglich, so dass ein Zeit- und Kostennachteil bei der Fertigung beheizbarer Verglasungen vorliegt.

Die Druckschrift DE 3445213 A1 offenbart ein Verfahren und eine Vorrichtung zur Kontrolle der Bindungsqualität von Kontaktstücken, indem der elektrische Widerstand zwischen einer Kontaktauflage und einem Kontaktträger gemessen wird.

Demgegenüber besteht die Aufgabe der vorliegenden Erfindung darin, eine Möglichkeit zu schaffen, die Kontaktqualität von Sammelleitern bereits im Herstellungsprozess überprüfen zu können. Diese und weiteren Aufgaben werden nach dem Vorschlag der Erfindung durch Anordnungen und Verfahren mit den Merkmalen der nebengeordneten Patentansprüche gelöst. Vorteilhafte Ausgestaltungen der Erfindung sind durch die Merkmale der Unteransprüche angegeben.

Erfindungsgemäß ist eine erste (Mess-)Anordnung zur Bestimmung des Kontaktwiderstands elektrisch leitfähiger Schichten gezeigt. Die Anordnung umfasst einen Schichtenaufbau, bei dem eine elektrisch leitfähige erste Schicht ("erste Schicht") auf eine elektrisch leitfähige zweite Schicht ("zweite Schicht") beispielsweise im Druckverfahren aufgebracht ist. In der Regel sind die beiden leitfähigen Schichten auf ein flächiges Substrat aufgebracht. Beispielsweise sind die beiden leitfähigen Schichten auf ein ebenes Substrat aufgebracht, wobei die beiden leitfähigen Schichten jeweils als ebene Schichten ausgebildet sind, mit Ebenen die zueinander und zur Ebene des Substrats parallel sind. Hierbei kontaktiert die erste Schicht die zweite Schicht in einem Kontakt- bzw. Übergangsbereich, im Weiteren als "Kontaktzone" bezeichnet, der über eine vorbestimmte bzw. vorbestimmbare (definierbare) Fläche verfügt. Die Kontaktzone wird somit gemeinsam von den beiden leitfähigen Schichten gebildet. Beispielsweise kontaktiert die erste leitfähige Schicht die zweite leitfähige Schicht direkt, d.h. ohne ein zwischen den beiden leitfähigen Schichten befindliches elektrisch leitfähiges Material, wie eine Lotschicht.

Die Anordnung umfasst weiterhin zwei an eine Stromquelle anschließbare bzw. angeschlossene Elektroden (in Weiteren zur einfacheren Bezugnahme als "Stromelektroden" bezeichnet), wobei die eine Stromelektrode mit der ersten Schicht und die andere Stromelektrode mit der zweiten Schichtelektrisch verbunden ist. Der durch die Kontaktzone fließende elektrische Strom hat eine vorbestimmte bzw. vorbestimmbare (bekannte) Stromstärke.

Zudem umfasst die erste Anordnung zwei an ein Spannungsmessgerät anschließbare bzw. angeschlossene Elektroden (im Weiteren zur einfacheren Bezugnahme als "Spannungsmesselektroden" bezeichnet), wobei die eine Spannungsmesselektrode in einer ersten Messzone mit der ersten Schicht und die andere Spannungsmesselektrode in einer zweiten Messzone mit der zweiten Schicht elektrisch verbunden ist. Hierbei ergibt sich die erste Messzone aus einem der Kontaktzone gegenüberliegenden Bereich der ersten Schicht und einem diesen Bereich quer zur Stromrichtung fluchtend verlängernden Bereich der ersten Schicht. Hierbei ergibt sich der der Kontaktzone gegenüber liegende Bereich der ersten Schicht durch jenen Bereich der ersten Schicht, der innerhalb einer zum Substrat senkrechten Verlängerung der Umrandung (Kontur) der Kontaktzone liegt. In einer analogen Definition ergibt sich der fluchtend verlängerte Bereich der ersten Messzone aus einer fluchtenden Verlängerung der ersten Schicht im Bereich der Kontaktzone quer zur Stromrichtung, da die Kontaktzone auch durch die erste Schicht gebildet wird. Der fluchtend verlängerte Bereich der ersten Messzone ergibt sich somit aus einem die Kontaktzone quer zur Stromrichtung fluchtend verlängernden Bereich der ersten Schicht.

Die zweite Messzone ergibt sich aus einem Bereich der zweiten Schicht, welcher einen der Kontaktzone gegenüberliegenden Bereich der zweiten Schicht quer zur Stromrichtung fluchtend verlängert. Hierbei ergibt sich der der Kontaktzone gegenüber liegende Bereich der zweiten Schicht durch jenen Bereich der zweiten Schicht, der innerhalb einer zum Substrat senkrechten Verlängerung der Umrandung (Kontur) der Kontaktzone liegt. In einer analogen Definition ergibt sich der fluchtend verlängerte Bereich der zweiten Messzone aus einer fluchtenden Verlängerung der zweiten Schicht im Bereich der Kontaktzone quer zur Stromrichtung, da die Kontaktzone auch durch die zweite Schicht gebildet wird. Die zweite Messzone ergibt sich somit aus einem die Kontaktzone quer zur Stromrichtung fluchtend verlängernden Bereich der zweiten Schicht.

In der erfindungsgemäß beanspruchten Anordnung sind die beiden Stromelektroden (zumindest gedanklich) durch eine gerade (kürzeste) Verbindungslinie miteinander verbunden bzw. verbindbar, welche sich insbesondere zur Ebene eines ebenen Substrats parallel erstreckt.

Die in der Beschreibung der Erfindung verwendete Formulierung "quer zur Stromrichtung" kann somit auch als quer zu einer geraden (kürzesten) Verbindungslinie zwischen den beiden Stromelektroden verstanden werden. Somit ergibt sich die erste Messzone aus einem der Kontaktzone gegenüberliegenden Bereich der ersten Schicht und einem diesen Bereich quer zu einer geraden Verbindungslinie zwischen den beiden Stromelektroden fluchtend verlängernden Bereich der ersten Schicht. Entsprechend ergibt sich die zweite Messzone aus einem die Kontaktzone quer zu einer geraden Verbindungslinie zwischen den beiden Stromelektroden fluchtend verlängernden Bereich der zweiten Schicht.

Weiterhin sind in der beanspruchten Anordnung die beiden Spannungsmesselektroden (zumindest gedanklich) durch eine gerade (kürzeste) Verbindungslinie miteinander verbunden bzw. verbindbar, welche sich insbesondere zur Ebene eines ebenen Substrats parallel erstreckt

Bei einer beispielhaften Ausgestaltung der erfindungsgemäßen Anordnung sind die beiden Spannungsmesselektroden zumindest annähernd quer bzw. quer (senkrecht) zu den beiden Stromelektroden angeordnet, wobei eine gerade (kürzeste) Verbindungslinie zwischen den beiden Spannungsmesselektroden zumindest annähernd quer bzw. quer (senkrecht) zu einer geraden (kürzesten) Verbindungslinie zwischen den beiden Stromelektroden gerichtet ist. Der Kontaktwiderstand der Kontaktzone kann auf Basis der gemessenen Potentialdifferenz und des erzeugten elektrischen Stroms, beispielsweise durch Anwenden des Ohm'schen Gesetzes, ermittelt werden.

Im Sinne vorliegender Erfindung bezieht sich der Ausdruck "Stromrichtung" auf die Richtung des Stroms entlang eines kürzesten Strompfads zwischen den beiden Stromelektroden. Im Sinne vorliegender Erfindung bezieht sich der Ausdruck "fluchtend verlängert" auf einen Bereich bzw. Abschnitt der jeweiligen leitfähigen Schicht, der sich durch eine Verlängerung der Kontaktzone bzw. der Außenkontur der Kontaktzone senkrecht zur Stromrichtung bzw. senkrecht zu einer geraden Verbindungslinie zwischen den beiden Stromelektroden ergibt. Hierbei ergibt sich der fluchtend verlängerte Bereich der jeweiligen leitfähigen Schicht durch eine Verlängerung senkrecht zur Stromrichtung bzw. senkrecht zu einer geraden Verbindungslinie zwischen den beiden Stromelektroden jenes Bereichs der jeweils leitfähigen Schicht, der innerhalb einer senkrecht zum Substrat gerichteten Verlängerung der Umrandung (Kontur) der Kontaktzone liegt.

Die erfindungsgemäße Anordnung ermöglicht in vorteilhafter Weise, den Spannungsabfall praktisch unmittelbar an der Kontaktzone zu messen. Hierbei bilden die erste Messzone und die zweite Messzone jeweils eine Äquipotenzialzone für das zu messenden elektrische Potenzial, so dass die Spannungsmesselektroden in besonders einfacher Weise lediglich jeweils innerhalb der zugeordneten Messzone positioniert werden müssen, um den Spannungsabfall an der Kontaktzone einfach, zuverlässig und sicher zu messen.

Bei einer Ausgestaltung der Anordnung kontaktieren die beiden Stromelektroden und die beiden Spannungsmesselektroden die erste bzw. zweite Schicht jeweils direkt, vorzugsweise durch Elektrodenspitzen.

Bei einer vorteilhaften Ausgestaltung der erfindungsgemäßen Anordnung umfassen die beiden elektrisch leitfähigen Schichten jeweils einen ersten Teil und einen mit diesem verbundenen zweiten Teil, wobei die beiden zweiten Teile jeweils quer zur Stromrichtung in fluchtender Verlängerung zur Kontaktzone angeordnet sind. Die Kontaktzone wird ausschließlich von den beiden ersten Teilen gebildet, d.h. die zweiten Teile formen die Kontaktzone nicht, wobei die zweite Messzone ausschließlich vom zweiten Teil der zweiten Schicht gebildet wird und der zweite Teil der ersten Schicht zumindest einen Abschnitt der ersten Messzone bildet. Hierbei ist die eine Stromelektrode mit dem ersten Teil der ersten Schicht und die andere Stromelektrode mit dem ersten Teil der zweiten Schicht elektrisch verbunden. Zudem ist die eine Spannungsmesselektrode mit dem ersten oder zweiten Teil der ersten Schicht und die andere Spannungsmesselektrode mit dem zweiten Teil der zweiten Schicht elektrisch verbunden.

Vorzugsweise sind die beiden zweiten Teile auf einander gegenüberliegenden Seiten der Kontaktzone angeordnet, wobei die beiden elektrisch leitfähigen Schichten beispielsweise jeweils in L-Form ausgebildet sind, mit einem ersten Teil und einem zumindest annähernd senkrecht davon abstehenden zweiten Teil.

Eine solche Anordnung ermöglicht eine besonders genaue und technisch einfach zu realisierende Bestimmung des Kontaktwiderstands an der Kontaktzone.

Erfindungsgemäß ist eine weitere zweite (Mess-)Anordnung zur Bestimmung des Kontaktwiderstands elektrisch leitfähiger Schichten gezeigt. Die Anordnung umfasst einen Schichtenaufbau, bei dem eine elektrisch leitfähige erste Schicht auf eine elektrisch leitfähige zweite Schicht aufgebracht ist. Die erste Schicht weist wenigstens zwei voneinander getrennte Schichtabschnitte auf, wobei ein erster Schichtabschnitt die zweite Schicht in einer Kontaktzone kontaktiert, welche über eine vorbestimmte bzw. vorbestimmbare (definierbare) Fläche verfügt.

In analoger Weise sind zwei Stromelektroden und zwei Spannungsmesselektroden angeordnet, wobei die eine Stromelektrode mit dem ersten Schichtabschnitt und die andere Stromelektrode mit dem zweiten Schichtabschnitt der ersten Schicht elektrisch verbunden ist. Die eine Spannungsmesselektrode ist in einer ersten Messzone mit der ersten Schicht verbunden, wobei sich die erste Messzone aus einem der Kontaktzone gegenüberliegenden Bereich des ersten Schichtabschnitts ergibt. Typsicher Weise entspricht die erste Messzone dem ersten Schichtabschnitt. Die andere Spannungsmesselektrode ist in einer zweiten Messzone mit der zweiten Schicht verbunden, wobei sich die zweite Messzone aus einem die Kontaktzone quer (senkrecht) zur Stromrichtung bzw. senkrecht zu einer geraden (kürzesten) Verbindungslinie zwischen den beiden Stromelektroden fluchtend verlängernden Bereich der zweiten Schicht ergibt. Die Schichtabschnitte der ersten Schicht können eine gleich große Kontaktfläche oder verschieden große Kontaktflächen haben, wobei es von Vorteil sein kann, wenn sie eine gleich große Kontaktfläche haben.

Bei einer vorteilhaften Ausgestaltung der erfindungsgemäßen Anordnung weist die erste Schicht wenigstens drei voneinander getrennte Schichtabschnitte auf, wobei ein erster Schichtabschnitt die zweite Schicht in der Kontaktzone kontaktiert. Hierbei sind die eine Stromelektrode und die eine Spannungsmesselektrode mit dem ersten Schichtabschnitt, die andere Stromelektrode mit einem zweiten Schichtabschnitt und die andere Spannungsmesselektrode mit einem dritten Schichtabschnitt elektrisch verbunden. Die Elektroden können die jeweilige Schicht beispielsweise direkt kontaktieren. Die Schichtabschnitte der ersten Schicht können eine gleich große Kontaktfläche oder verschieden große Kontaktflächen haben, wobei es von Vorteil sein kann, wenn sie eine gleich große Kontaktfläche haben.

Vorzugsweise ist die zweite Schicht so unterteilt, dass der erste Schichtabschnitt und der dritte Schichtabschnitt durch einen quer zur Stromrichtung sich erstreckenden Verbindungssteg der zweiten Schicht elektrisch miteinander verbunden sind, wobei der Verbindungssteg in fluchtender Verlängerung zur Kontaktzone angeordnet ist. Vorzugsweise ist eine Abmessung des Verbindungsstegs in Stromrichtung gleich zu oder stärker bevorzugt kleiner als eine entsprechende Abmessung der Kontaktzone. Weiterhin kann es von Vorteil sein, wenn der dritte Schichtabschnitt quer zur Stromrichtung in fluchtender Verlängerung zur Kontaktzone angeordnet ist.

Die Erfindung erstreckt sich weiterhin auf ein erstes Verfahren zur Bestimmung des Kontaktwiderstands elektrisch leitfähiger Schichten, welches umfasst:
Einen Schritt zum Bereitstellen einer wie oben beschriebenen Anordnung bzw. eines Schichtenaufbaus, bei dem eine leitfähige erste Schicht auf eine leitfähige zweite Schicht aufgebracht ist, wobei die erste Schicht die zweite Schicht in einer Kontaktzone kontaktiert.

Einen Schritt zum Erzeugen eines elektrischen Stroms durch die Kontaktzone, wobei eine Stromelektrode mit der ersten Schicht und eine andere Stromelektrode mit der zweiten Schicht elektrisch verbunden werden.

Einen Schritt zum Messen einer Potentialdifferenz an der Kontaktzone, wobei eine Spannungsmesselektrode in einer ersten Messzone mit der ersten Schicht verbunden wird, wobei sich die erste Messzone aus einem der Kontaktzone gegenüberliegenden Bereich der ersten Schicht und einem diesen Bereich quer zur Stromrichtung bzw. quer zu einer geraden (kürzesten) Verbindungslinie zwischen den beiden Stromelektroden fluchtend verlängernden Bereich der ersten Schicht ergibt, und wobei eine andere Spannungsmesselektrode in einer zweiten Messzone mit der zweiten Schicht verbunden wird, wobei sich die zweite Messzone aus einem die Kontaktzone quer zur Stromrichtung bzw. quer zu einer geraden (kürzesten) Verbindungslinie zwischen den beiden Stromelektroden fluchtend verlängernden Bereich der zweiten Schicht ergibt.

Ferner erstreckt sich die Erfindung auf ein zweites Verfahren zur Bestimmung des Kontaktwiderstands elektrisch leitfähiger Schichten, welches umfasst:
Einen Schritt zum Bereitstellen einer wie oben beschriebenen Anordnung bzw. eines Schichtenaufbaus, bei dem eine leitfähige erste Schicht auf eine leitfähige zweite Schicht aufgebracht ist, wobei die erste Schicht wenigstens zwei voneinander getrennte Schichtabschnitte aufweist, wobei ein erster Schichtabschnitt die zweite Schicht in einer Kontaktzone kontaktiert.

Einen Schritt zum Erzeugen eines elektrischen Stroms durch die Kontaktzone, wobei eine Stromelektrode mit dem ersten Schichtabschnitt und eine andere Stromelektrode mit dem zweiten Schichtabschnitt elektrisch verbunden werden. Einen Schritt zum Messen einer Potentialdifferenz an der Kontaktzone, wobei eine Spannungsmesselektrode in einer ersten Messzone mit dem ersten Schichtabschnitt verbunden wird, wobei sich die erste Messzone aus einem der Kontaktzone gegenüberliegenden Bereich des ersten Schichtabschnitts ergibt, und wobei eine andere Spannungsmesselektrode in einer zweiten Messzone mit dem zweiten Schichtabschnitt verbunden wird, wobei sich die zweite Messzone aus einem die Kontaktzone quer zur Stromrichtung bzw. quer zu einer geraden (kürzesten) Verbindungslinie zwischen den beiden Stromelektroden fluchtend verlängernden Bereich der zweiten Schicht ergibt.

Bei einer vorteilhaften Ausgestaltung des Verfahrens wird eine wie oben beschriebene Anordnung bzw. ein Schichtenaufbau bereitgestellt, bei dem die erste Schicht wenigstens drei voneinander getrennte Schichtabschnitte aufweist, wobei ein erster Schichtabschnitt die zweite Schicht in der Kontaktzone kontaktiert. Hierbei werden die eine Stromelektrode und die eine Spannungsmesselektrode mit dem ersten Schichtabschnitt, die andere Stromelektrode mit einem zweiten Schichtabschnitt und die andere Spannungsmesselektrode mit einem dritten Schichtabschnitt elektrisch verbunden.

Ferner erstreckt sich die Erfindung auf die Verwendung solcher Verfahren zur Bestimmung des Kontaktwiderstands wenigstens einer auf eine Funktionsschicht aufgebrachten Elektrodenschicht eines Flächenkörpers. Insbesondere bezieht sie sich auf die Verwendung solcher Verfahren zur Bestimmung des Kontaktwiderstands wenigstens eines auf eine Heizschicht aufgebrachten flächigen Sammelleiters eines Flächenheizkörpers oder zur Bestimmung des Kontaktwiderstands einer auf eine Flächenantenne aufgebrachten Elektrode.

Ein zur Durchführung des obigen ersten Verfahrens geeignet ausgebildeter erster Flächenkörper umfasst wenigstens ein

(flächiges) Substrat und einen Schichtenaufbau, bei dem eine elektrisch leitfähige erste Schicht, beispielsweise eine Elektrodenschicht, auf eine elektrisch leitfähige zweite Schicht, beispielsweise eine Funktionsschicht, aufgebracht ist, welche die erste Schicht in einer Kontaktzone kontaktiert.

Der Begriff "Funktionsschicht" bezieht sich auf eine elektrisch leitfähige Schicht mit einer Funktion im Hinblick auf den bestimmungsgemäßen Gebrauch des Flächenkörpers. Beispielsweise dient die Funktionsschicht als elektrische Heizschicht zum Heizen des Flächenkörpers oder als Flächenantenne zum Empfang elektromagnetischer Signale. Der Begriff "Elektrodenschicht" bezieht sich auf eine elektrisch leitfähige Schicht, welche die Funktionsschicht (direkt) elektrisch kontaktiert, beispielsweise zum Speisen der Heizschicht mit Heizstrom oder zum Ableiten von Antennensignalen aus der Flächenantenne.

So kann der Flächenkörper beispielsweise in Form eines (Flächen-)Heizkörpers, insbesondere beheizbare Verglasung, ausgebildet sein, mit einer als Heizschicht dienenden Funktionsschicht und wenigstens zwei Elektrodenschichten, die als Sammelleiter zum Speisen der Heizschicht mit einem Heizstrom dienen. Bei dem Heizkörper kann es sich insbesondere um eine transparente oder opake beheizbare Verglasung handeln, welche als funktionales Einzelstück oder als Einbauteil in Möbeln, Geräten und Gebäuden, sowie in Fortbewegungsmitteln zur Fortbewegung auf dem Lande, in der Luft oder zu Wasser, insbesondere in Kraftfahrzeugen beispielsweise als Windschutzscheibe, Heckscheibe, Seitenscheibe und/oder Glasdach, ausgebildet sein kann. Der Flächenkörper kann beispielsweise auch in Form eines Antennenkörpers ausgebildet sein, mit einer als Flächenantenne dienenden Funktionsschicht und wenigstens einer als Antennenelektrode zum Ableiten von Antennensignalen aus der Flächenantenne dienenden Elektrodenschicht.

Die beiden Schichten umfassen jeweils einen ersten Teil und einen damit verbundenen zweiten Teil, wobei die Kontaktzone ausschließlich von den beiden ersten Teilen gebildet wird und die beiden zweiten Teile jeweils quer zur einer vorgebbaren bzw. vorgegebenen Richtung (entsprechend der Stromrichtung in obiger erster Anordnung) in fluchtender Verlängerung zur Kontaktzone angeordnet sind. Vorzugsweise sind die beiden zweiten Teile auf einander gegenüberliegenden Seiten der Kontaktzone angeordnet.

Beispielsweise umfassen die elektrisch leitfähige erste Schicht, beispielsweise Elektrodenschicht, und die elektrisch leitfähige zweite Schicht, beispielsweise Funktionsschicht jeweils einen Messabschnitt und einen Funktionsabschnitt, die elektrisch voneinander getrennt sind. Hierbei kontaktiert der Messabschnitt der ersten Schicht den Messabschnitt der zweiten Schicht an der Kontaktzone. Zur Durchführung des erfindungsgemäßen ersten Verfahrens ist die erfindungsgemäße erste Anordnung an beiden Messabschnitten angeordnet, wobei die eine Stromelektrode mit dem Messabschnitt der ersten Schicht und die andere Stromelektrode mit dem Messabschnitt der zweiten Schicht elektrisch verbunden ist. Zudem ist die eine Spannungsmesselektrode in einer ersten Messzone mit dem Messabschnitt der ersten Schicht verbunden, wobei sich die erste Messzone aus einem der Kontaktzone gegenüberliegenden Bereich der ersten Schicht und einem diesen Bereich quer zur Stromrichtung fluchtend verlängernden Bereich der ersten Schicht ergibt. Die andere Spannungsmesselektrode ist in einer zweiten Messzone mit dem Messabschnitt der zweiten Schicht verbunden, wobei sich die zweite Messzone aus einem die Kontaktzone quer zur Stromrichtung fluchtend verlängernden Bereich der zweiten Schicht ergibt.

Ein zur Durchführung des obigen zweiten Verfahrens geeignet ausgebildeter zweiter Flächenkörper umfasst wenigstens ein (flächiges) Substrat und einen Schichtenaufbau, bei dem eine elektrisch leitfähige erste Schicht auf eine elektrisch leitfähige zweite Schicht aufgebracht ist. Die erste Schicht weist zwei voneinander getrennte Schichtabschnitte auf, wobei ein erster Schichtabschnitt die zweite Schicht in der Kontaktzone kontaktiert, deren elektrischer Widerstand bestimmt werden soll. Ein zweiter Schichtabschnitt kontaktiert die zweite Schicht. Zur Durchführung des erfindungsgemäßen ersten Verfahrens ist die erfindungsgemäße zweite Anordnung so angeordnet, dass die eine Stromelektrode mit dem ersten Schichtabschnitt und die andere Stromelektrode mit dem zweiten Schichtabschnitt der ersten Schicht elektrisch verbunden ist. Zudem ist die eine Spannungsmesselektrode in einer ersten Messzone mit der ersten Schicht verbunden, wobei sich die erste Messzone aus einem der Kontaktzone gegenüberliegenden Bereich des ersten Schichtabschnitts ergibt, und die andere Spannungsmesselektrode ist in einer zweiten Messzone mit der zweiten Schicht verbunden, wobei sich die zweite Messzone aus einem die Kontaktzone quer zur Stromrichtung fluchtend verlängernden Bereich der zweiten Schicht ergibt.

Ein zur Durchführung des obigen zweiten Verfahrens geeignet ausgebildeter dritter Flächenkörper umfasst wenigstens ein (flächiges) Substrat und einen Schichtenaufbau, bei dem eine elektrisch leitfähige erste Schicht auf eine elektrisch leitfähige zweite Schicht aufgebracht ist. Die erste Schicht weist wenigstens drei voneinander getrennte Schichtabschnitte auf, wobei ein erster Schichtabschnitt die zweite Schicht in einer Kontaktzone kontaktiert. Hierbei ist die zweite Schicht so unterteilt, dass der erste Schichtabschnitt und ein zweiter Schichtabschnitt durch einen Verbindungssteg der zweiten Schicht mit einem dritten Schichtabschnitt elektrisch verbunden sind, wobei sich der Verbindungssteg quer zur einer Richtung erstreckt, entlang welcher der erste und zweite Schichtabschnitt angeordnet sind (entsprechend der Stromrichtung in obiger Anordnung), wobei der Verbindungssteg in fluchtender Verlängerung zur Kontaktzone angeordnet ist.

Vorzugsweise ist eine Abmessung des Verbindungsstegs in der Richtung, entlang welcher der erste und zweite Schichtabschnitt angeordnet sind, gleich zu oder kleiner als eine entsprechende Abmessung der Kontaktzone. Weiterhin ist es bevorzugt, dass der dritte Schichtabschnitt quer zur Richtung, entlang welcher der erste und zweite Schichtabschnitt angeordnet sind, in fluchtender Verlängerung zur Kontaktzone angeordnet ist.

Zur Durchführung des erfindungsgemäßen zweiten Verfahrens ist die erfindungsgemäße zweite Anordnung so angeordnet, dass die eine Stromelektrode und die eine Spannungsmesselektrode mit dem ersten Schichtabschnitt, die andere Stromelektrode mit dem zweiten Schichtabschnitt und die andere Spannungsmesselektrode mit dem dritten Schichtabschnitt elektrisch verbunden sind.

Ferner erstreckt sich die Erfindung auf die Verwendung solcher Anordnungen zur Bestimmung des Kontaktwiderstands wenigstens einer auf eine Funktionsschicht aufgebrachten Elektrodenschicht eines Flächenkörpers. Insbesondere bezieht sie sich auf die Verwendung solcher Anordnungen zur Bestimmung des Kontaktwiderstands wenigstens eines auf eine Heizschicht aufgebrachten flächigen Sammelleiters eines Flächenheizkörpers oder zur Bestimmung des Kontaktwiderstands einer auf eine Flächenantenne aufgebrachten Elektrode. Der Flächenkörper kann wie vorstehend beschrieben ausgebildet sein.

Es versteht sich, dass die vorstehend genannten und nachstehend zu erläuternden Merkmale nicht nur in den angegebenen Kombinationen, sondern auch in anderen Kombinationen oder in Alleinstellung einsetzbar sind, ohne den Rahmen der vorliegenden Erfindung zu verlassen.

### Kurze Beschreibung der Zeichnungen

Die Erfindung wird nun anhand von Ausführungsbeispielen näher erläutert, wobei Bezug auf die beigefügten Figuren genommen wird. Es zeigen in vereinfachter, nicht maßstäblicher Darstellung:
- Fig. 1: eine (Teil-)Querschnittsdarstellung eines Flächenkörpers im Bereich einer Elektrodenschicht;
- Fig. 2: eine schematische perspektivische Darstellung eines Schichtenaufbaus zur Bestimmung des Kontaktwiderstands;
- Fig. 3: eine Messanordnung zur Messung des Kontaktwiderstands im Schichtenaufbau von Fig. 2;
- Fig. 4: eine weitere Messanordnung zur Messung des Kontaktwiderstands eines Flächenkörpers;
- Fig. 5: eine weitere Messanordnung zur Messung des Kontaktwiderstands eines Flächenkörpers.

### Ausführliche Beschreibung der Zeichnungen

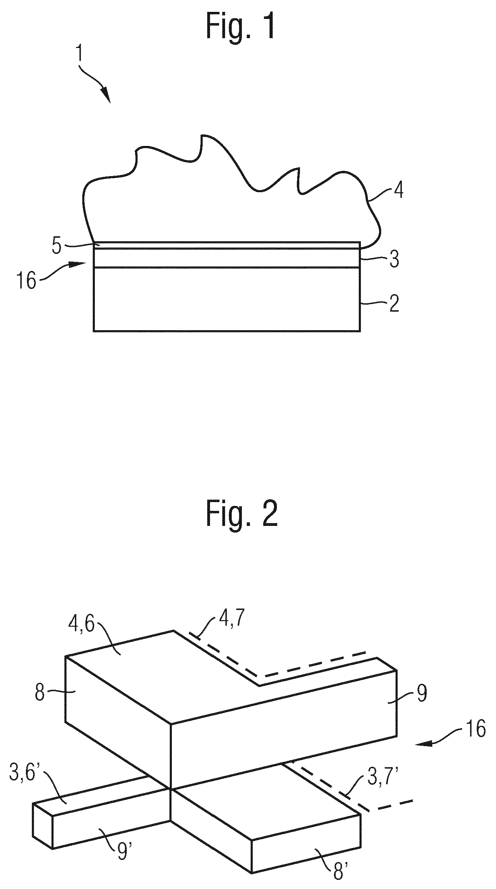

Sei zunächst Figur 1 betrachtet, worin in einer schematischen Schnittdarstellung ein Abschnitt eines insgesamt mit der Bezugszahl 1 bezeichneten Flächenkörpers gezeigt ist. Bei dem Flächenkörper 1 kann es sich beispielsweise um eine elektrisch beheizbare Verglasung oder eine Flächenantenne handeln.

Der Flächenkörper 1 umfasst ein Substrat 2, auf dem eine elektrisch leitfähige Funktionsschicht 3 (z.B. Heizschicht) aufgebracht ist. Das Substrat 2 ist beispielsweise aus Glas gefertigt, wobei es gleichermaßen aber auch aus einem nichtgläsernen Material wie Kunststoff hergestellt sein kann. Beispielweise können Flachglas, Floatglas, Quarzglas, Borsilikatglas, Kalk-Natron-Glas, oder klare Kunststoffe, insbesondere starre klare Kunststoffe, beispielsweise Polyethylen, Polypropylen, Polycarbonat, Polymethylmethacrylat, Polystyrol, Polyamid, Polyester, Polyvinylchlorid und/oder Gemische hiervon, als Substratmaterial verwendet werden, wobei diese Aufzählung nicht abschließend ist. Beispiele geeigneter Gläser können insbesondere dem europäischen Patent EP 0847965 B1 entnommen werden.

Je nach Anwendung kann die Dicke des Substrats 2 breit variieren. Für eine beheizbare Verglasung, insbesondere eine transparente Scheibe, liegt die Dicke des Substrats beispielsweise im Bereich von 1 bis 25 mm, wobei für transparente Scheiben typischer Weise eine Dicke von 1,4 bis 2,1 mm verwendet wird. Das Substrat 2 kann planar (flächig eben) oder in eine oder mehrere Raumrichtungen gebogen sein.

Obgleich in Fig. 1 nur ein einziges Substrat 2 gezeigt ist, versteht es sich, dass gleichermaßen zwei oder mehr Substrate, beispielsweise zur Formung einer Verbundscheibenstruktur, vorgesehen sein können.

Das Substrat 2 kann beispielsweise im Wesentlichen vollflächig mit der Funktionsschicht 3 beschichtet sein (Beschichtungsgrad z.B. 90%). Bei der Funktionsschicht 3 kann es sich beispielsweise um eine transparente Beschichtung handeln, die für elektromagnetische Strahlung, vorzugsweise elektromagnetische Strahlung einer Wellenlänge von 300 bis 1300 nm, insbesondere für sichtbares Licht, durchlässig ist. Der Begriff "durchlässig" bezieht sich hier auf eine Gesamttransmission des Flächenkörpers 1, die insbesondere für sichtbares Licht beispielsweise >70% und insbesondere >80% ist. Fahrzeug-Windschutzscheiben haben typsicher Weise eine Transmission von ca. 71%. Solche Schichten sind beispielsweise aus den Druckschriften DE 202008017611 U1 und EP 0847965 B1 bekannt.

Insbesondere zur Verwendung als Heizschicht kann die Funktionsschicht 3 beispielsweise aus einer Metallschicht wie eine Silberschicht oder eine silberhaltige Metalllegierung, die zwischen mindestens zwei Beschichtungen aus dielektrischem Material vom Typ Metalloxid eingebettet ist, bestehen. Das Metalloxid enthält beispielsweise Zinkoxid, Zinnoxid, Indiumoxid, Titanoxid, Siliziumoxid, Aluminiumoxid oder dergleichen sowie Kombinationen von einem oder mehreren hieraus. Das dielektrische Material kann auch Siliziumnitrid, Siliziumcarbid oder Aluminiumnitrid enthalten. Beispielsweise können Metallschichtsysteme mit mehreren Metallschichten verwendet werden, wobei die einzelnen Metallschichten durch mindestens eine Schicht aus dielektrischem Material getrennt sind.

Ein solcher Schichtenaufbau wird typischer Weise durch eine Folge von Abscheidevorgängen erhalten, die durch ein Vakuumverfahren wie die magnetfeldgestützte Kathodenzerstäubung (Sputtern) durchgeführt werden. Auf beiden Seiten der Silberschicht können sehr feine Metallschichten vorgesehen werden, die insbesondere Titan oder Niob enthalten. Die untere Metallschicht dient als Haft- und Kristallisationsschicht. Die obere Metallschicht dient als Schutz- und Getterschicht, um eine Veränderung des Silbers während der weiteren Prozessschritte zu verhindern. Vorteilhaft ist die Schichtenfolge thermisch hoch belastbar, so dass sie die zum Biegen von Glasscheiben erforderlichen Temperaturen von typischer Weise mehr als 600°C ohne Schädigung übersteht, wobei aber auch thermisch gering belastbare Schichtenfolgen vorgesehen sein können. Ebenso ist denkbar, die Funktionsschicht 3 nicht direkt auf das Substrat 2 aufzubringen, sondern diese zunächst auf einen Träger, beispielsweise eine Kunststofffolie, aufzubringen, der anschließend mit dem Substrat 2 verklebt wird.

Die Dicke der Funktionsschicht 3 kann breit variieren und den Erfordernissen des Einzelfalls angepasst werden. Wesentlich hierbei ist, dass bei einem transparenten Flächenkörper 1 die Dicke der Funktionsschicht 3 nicht so hoch werden darf, dass sie für elektromagnetische Strahlung, vorzugsweise elektromagnetische Strahlung einer Wellenlänge von 300 bis 1300 nm und insbesondere sichtbares Licht, undurchlässig wird. Beispielsweise liegt die Dicke der Funktionsschicht 3 im ein- oder zweistelligen µm-Bereich. Die Funktionsschicht 3 hat beispielsweise einen Flächenwiderstand im Bereich von 1 Ohm/Quadrat bis 10 Ohm/Quadrat, insbesondere im Bereich von 1 Ohm/Quadrat bis 5 Ohm/Quadrat.

Auf die Funktionsschicht 3 ist eine elektrisch leitfähige Elektrodenschicht 4 aufgebracht, bei der es sich beispielsweise um einen streifen- bzw. bandförmigen Sammelleiter handelt, welcher zum breit verteilten Einleiten des Heizstroms in die als Heizschicht dienende Funktionsschicht 3 dient. Beispiele für derartige Elektrodenschichten sind beispielsweise aus den Druckschriften DE 103 33 618 B3 und EP 0 025 755 B1 bekannt. Die Elektrodenschicht 4 ist durch Aufdrucken einer beispielsweise metallischen Druckpaste auf die Funktionsschicht 3 (z.B. Siebdruckverfahren) hergestellt. Anschließend wird die Druckpaste eingebrannt. Generell kann als Material für die Elektrodenschicht 4 beispielsweise ein Metall wie Silber (Ag), insbesondere in Form einer Druckpaste zur Verwendung im Druckverfahren, Kupfer (Cu), Aluminium (Al) und Zink (Zn), oder eine Metalllegierung verwendet werden, wobei diese Aufzählung nicht abschließend ist. Beispielsweise enthält die Druckpaste Silber-Partikel und Glasfritten.

Die Schichtdicke der Elektrodenschicht 4 hängt allgemein vom verwendeten Sammelleitermaterial ab und liegt beispielsweise im Bereich von 5 bis 25 µm, insbesondere im Bereich von 10 bis 15 µm. Der spezifische elektrische Widerstand der Elektrodenschicht 4 hängt allgemein vom verwendeten Sammelleitermaterial ab, wobei er insbesondere für eine gedruckte Elektrodenschicht 4 im Bereich von 2 bis 4 Mikroohm·Zentimeter (µOhm·cm) liegt. Beispielsweise beträgt der spezifische elektrische Widerstand einer 80%-igen Silberdruckpaste für das Siebdruckverfahren 2,8 µOhm·cm. Die Elektrodenschicht 4 ist im Vergleich zur hochohmigen Funktionsschicht 3 relativ niederohmig. Beispielsweise liegt der elektrische Widerstand pro Längeneinheit im Bereich von 0,15 bis 4 **Ω**/m. Die Breite einer streifenförmigen Elektrodenschicht 4 liegt beispielsweise im Bereich von 1 bis 20 mm.

Wie bereits ausgeführt, kann die Elektrodenschicht 4 durch Aufdrucken einer metallischen Druckpaste auf die Funktionsschicht 3 hergestellt werden. Alternativ ist es auch möglich, dass hierfür ein dünner Metallfolienstreifen verwendet wird, welcher beispielsweise Kupfer und/oder Aluminium enthält. Beispielsweise in einem Autoklavprozess durch die Einwirkung von Wärme und Druck kann ein elektrischer Kontakt zwischen dem Metallfolienstreifen und der Funktionsschicht 3 erreicht werden. Der elektrische Kontakt kann aber auch durch Auflöten oder Kleben mit einem elektrisch leitfähigen Kleber hergestellt werden. Vorzugsweise ist die Elektrodenschicht 4 mit der Funktionsschicht 3 direkt (d.h. ohne dazwischen befindliches elektrisch leitfähiges Material) elektrisch verbunden.

Obgleich in Fig. 1 nur eine einzige Elektrodenschicht 4 gezeigt ist, versteht es sich, dass der Flächenkörper 1 mehr als eine Elektrodenschicht 4 umfassen kann, beispielsweise bei einer beheizbaren Verglasung zumindest ein Paar Elektrodenschichten 4, die zur Verbindung mit den beiden Polen einer Spannungsquelle vorgesehen sind. Zur Kontaktierung der Elektrodenschicht 4 wird in der Regel eine Zuleitung (nicht gezeigt) eingesetzt, welche beispielsweise in Form eines Folienleiters ausgebildet ist. Eine geeignete Zuleitung ist beispielsweise in den Druckschriften DE 42 35 063 A1, DE 20 2004 019 286 U1 und DE 93 13 394 U1 beschrieben.

Die Elektrodenschicht 4 kontaktiert die Funktionsschicht 3 in einem flächigen Übergangs- bzw. Kontaktbereich, im Weiteren als "Kontaktzone 5" bezeichnet. Vom Übergangs- bzw. Kontaktwiderstand der Kontaktzone 5 hängt die Qualität der elektrischen Kontaktierung der Funktionsschicht 3 durch die Elektrodenschicht 4 ab, wobei ein großer Kontaktwiderstand zu einer relativ hohen elektrischen Verlustleistung führt, was zur Folge hat, dass sich die Kontaktzone 5 relativ stark erwärmt.

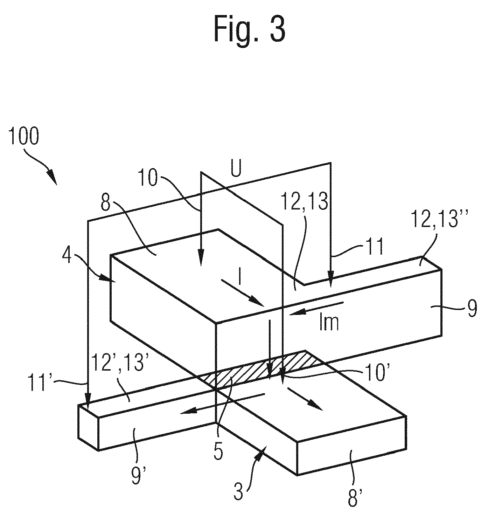

Es seien nun die Figuren 2 und 3 betrachtet, worin ein Ausführungsbeispiel einer erfindungsgemäßen Messanordnung 100 zur Bestimmung des elektrischen Kontaktwiderstands des Flächenkörpers 1 von Fig. 1 veranschaulicht ist.

Demnach verfügt die Funktionsschicht 3 über zwei voneinander getrennte Abschnitte, nämlich einen Messabschnitt 6' und einen Funktionsabschnitt 7'. In entsprechender Weise verfügt die Elektrodenschicht 4 über zwei voneinander getrennte Abschnitte, nämlich einen Messabschnitt 6 und einen Funktionsabschnitt 7. Zur Bildung der Messabschnitte 6, 6' und Funktionsabschnitte 7, 7' ist die Funktions- und Elektrodenschicht 3, 4 durch vollständig durchtrennende Einschnitte unterteilt. Die Einschnitte können beispielsweise mittels eines Lasers nachträglich in die Funktions- bzw. Elektrodenschicht 3,4 eingearbeitet werden. Geeignete Verfahren zum Strukturieren dünner Metallfilme sind beispielsweise aus EP 2200097 A1 oder EP 2139049 A1 bekannt. Alternativ können die Einschnitte durch mechanisches Abtragen sowie durch chemisches oder physikalisches Ätzen ausgebildet werden. Alternativ wäre es auch möglich, die verschiedenen Abschnitte 6, 6', 7, 7' von Funktions- bzw. Elektrodenschicht 3, 4 schon bei der Schichtherstellung auszubilden.

Die beiden Messabschnitte 6, 6' dienen nur für eine Bestimmung des Kontaktwiderstands, jedoch nicht für einen bestimmungsgemäßen Gebrauch von Funktions- bzw. Elektrodenschicht 3, 4. Andererseits dienen die beiden Funktionsabschnitte 7, 7' nur für einen bestimmungsgemäßen Gebrauch der Funktions- bzw. Elektrodenschicht 3, 4, beispielsweise als Heizschicht oder Antennenfläche bzw. als Sammelleiter oder Antennenelektrode. Beispielsweise ist bei der Ausgestaltung als Flächenheizkörper nur der Funktionsabschnitt 7 der Elektrodenschicht 4 mit einer Zuleitung zur Verbindung mit dem Pol einer Spannungsquelle elektrisch verbunden.

Die beiden Messabschnitte 6, 6' überlappen sich teilweise, wobei sie an der Kontaktzone 5, welche hier beispielsweise eine Rechteckform hat, Berührungskontakt haben. Die beiden Messabschnitte 6, 6' sind jeweils in L-Form ausgebildet, mit einem ersten Teil 8, 8' und einem beispielsweise zumindest annähernd rechtwinklig vom ersten Teil 8, 8' abstehenden zweiten Teil 9, 9'. Die beiden ersten Teile 8, 8' sind abschnittsweise übereinander liegend angeordnet und bilden so die Kontaktzone 5. Die beiden zweiten Teile 9, 9' sind in fluchtender Verlängerung der Kontaktzone 5 (in der Projektion auf die Ebene der Kontaktzone 5) und auf beiden Seiten der Kontaktzone 5 angeordnet.

Um den Kontaktwiderstand der Kontaktzone 5 der beiden Messabschnitte 6, 6' zu bestimmen, werden zwei Stromelektroden 10, 10' und zwei Spannungsmesselektroden 11, 11' in Stellung gebracht, die jeweils über eine Elektrodenspitze zur Kontaktierung der jeweiligen Schicht verfügen, welche in Figur 3 durch eine Pfeilspitze symbolisch dargestellt ist. Zu diesem Zweck kontaktiert eine Stromelektrode 10' direkt den ersten Teil 8' des Messabschnitts 6' der Funktionsschicht 3, die andere Stromelektrode 10 den ersten Teil 8 des Messabschnitts 6 der Elektrodenschicht 4. Der Abstand zwischen den beiden Stromelektroden 10, 10' liegt beispielsweise im ein- oder zweistelligen Millimeterbereich. Die beiden Stromelektroden 10, 10' sind mit einer Stromquelle (nicht gezeigt) zur Bereitstellung eines Stroms konstanter Stromstärke (z.B. 0,1 bis 1 Ampere) elektrisch verbunden, so dass ein Strom I konstanter Stromstärke durch die Kontaktzone 5 fließt. Wie in Figur 3 veranschaulicht, fließt der Strom zwischen den beiden Stromelektroden 10, 10' in der Ebene der Elektrodenschicht 4 und Funktionsschicht 3, wobei er senkrecht zu den Schichtebenen die Kontaktzone 5 passiert.

Die beiden Spannungsmesselektroden 11, 11' (bzw. eine gerade Verbindungslinie zwischen diesen) sind zumindest annähernd senkrecht zur Stromrichtung (betrachtet im Stromverlauf entlang den Schichtenebenen) angeordnet. Somit sind die beiden Spannungsmesselektroden 11, 11' zumindest annähernd senkrecht zu den beiden Stromelektroden 10, 10' (bzw. eine gerade Verbindungslinie zwischen diesen) angeordnet. Hierbei kontaktiert eine Spannungsmesselektrode 11' direkt den zweiten Teil 9' des Messabschnitts 6' der Funktionsschicht 3, die andere Spannungsmesselektrode 11 kontaktiert direkt den zweiten Teil 9 des Messabschnitts 6 der Elektrodenschicht 4. Der Abstand zwischen den beiden Spannungsmesselektroden 11, 11' liegt beispielsweise im ein- oder zweistelligen Millimeterbereich.

Die eine Spannungsmesselektrode 11' kontaktiert den Messabschnitt 6' der Funktionsschicht 3 innerhalb einer ersten Messzone 12', die sich aus einem die Kontaktzone 5 quer zur Stromrichtung fluchtend verlängernden Bereich 13' der Funktionsschicht 3 ergibt und hier dem zweiten Teil 9' des Messabschnitts 6' entspricht. Die andere Spannungsmesselektrode 11 kontaktiert den Messabschnitt 6 der Elektrodenschicht 4 innerhalb einer zweiten Messzone 12, die sich aus einem der Kontaktzone 5 gegenüberliegenden Bereich 13 und einem diesen Bereich 13 quer zur Stromrichtung verlängernden Bereich 13'' der Elektrodenschicht 4 ergibt. Im gezeigten Ausführungsbeispiel kontaktiert die Spannungsmesselektrode 11 den Messabschnitt 6 beispielsweise in dessen zweiten Teil 9.

Die beiden Spannungsmesselektroden 11, 11' sind zur Messung einer Potentialdifferenz an ein Spannungsmessgerät (nicht gezeigt) angeschlossen. Die Schichtdicke der Elektrodenschicht 4 liegt im ein- oder zweistelligen µm-Bereich, so dass senkrecht zu den Schichtebenen praktisch kein Spannungsabfall auftritt. Durch die beiden Spannungsmesselektroden 11, 11' kann somit der Spannungsabfall unmittelbar an der Kontaktzone 5 gemessen werden. Die beiden Messzonen 12, 12' bilden jeweils eine Äquipotentialzone für das elektrische Potenzial auf der einen bzw. anderen Seite der Kontaktzone 5. Eine genaue Positionierung der Spannungsmesselektroden 11, 11' innerhalb der jeweiligen Messzone 12, 12' ist somit nicht erforderlich.

Die Messung der Potentialdifferenz durch die beiden Spannungsmesselektroden 11, 11' erfolgt aufgrund eines sehr hohen Innenwiderstands des Spannungsmessgeräts praktisch stromlos, so dass ein Messstrom Iₘ verschwindend gering, jedenfalls sehr viel kleiner als der Strom I zwischen den beiden Stromelektroden 10, 10' ist (I >> Iₘ). Somit kann der Kontaktwiderstand der Kontaktzone 5 aus dem Ohm'schen Gesetz berechnet werden (R = U/I), wobei die gemessene Potentialdifferenz an der Kontaktzone 5 durch die Stromstärke des angelegten Stroms geteilt wird. Durch die beiden Messabschnitte 6, 6' wird eine definierte elektrische Messumgebung zur Messung der Potentialdifferenz an der Kontaktzone 5 geschaffen, die gezielt an das Messverfahren angepasst werden kann.

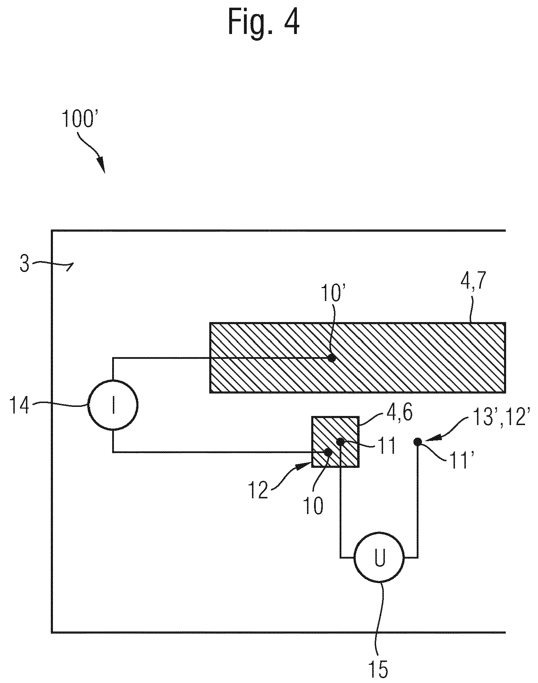

In Fig. 4 ist eine alternative Messanordnung 100' zur Messung des Kontaktwiderstands zwischen Funktions- und Elektrodenschicht 3, 4 veranschaulicht. Um unnötige Wiederholungen zu vermeiden, werden lediglich die Unterschiede zu der in den Figuren 2 und 3 veranschaulichten Messanordnung 100 erläutert und ansonsten wird auf die dort gemachten Ausführungen Bezug genommen.

Demnach umfasst die Messanordnung 100' eine Elektrodenschicht 4 mit einem Messabschnitt 6 und einem davon abgetrennten Funktionsabschnitt 7. Die Funktionsschicht 3 ist nicht in verschiedene Abschnitte unterteilt. Der Messabschnitt 6 hat hier beispielsweise eine rechteckige, insbesondere quadratische Form, wobei sich die Kontaktzone 5 über den vollständigen Messabschnitt 6 erstreckt.

Um den Kontaktwiderstand der Kontaktzone 5 zu bestimmen, kontaktiert die eine Stromelektrode 10 direkt den Messabschnitt 6, die andere Stromelektrode 10' kontaktiert direkt den Funktionsabschnitt 7 und ist somit mittelbar mit der Funktionsschicht 3 elektrisch verbunden. Die beiden Spannungsmesselektroden 11, 11' sind wiederum quer zur Stromrichtung angeordnet, wobei die eine Spannungsmesselektrode 11' direkt die Funktionsschicht 3 in der ersten Messzone 12' kontaktiert, welche sich aus einem die Kontaktzone 5 quer zur Stromrichtung fluchtend verlängernden Bereich 13' der Funktionsschicht 3 ergibt. Die andere Spannungsmesselektrode 11 kontaktiert direkt den Messabschnitt 6 in einer zweiten Messzone 12, die aus der kompletten Oberfläche des Messabschnitts 6 gebildet wird. Die beiden Messzonen 12, 12' bilden jeweils eine Äquipotentialfläche für das zu messende Potential, so dass eine genaue Positionierung der Spannungsmesselektroden 11, 11' innerhalb der zugeordneten Messzonen 12, 12' nicht erforderlich ist.

In einer nicht gezeigten Variante der Messanordnung 100' von Figur 4 ist innerhalb der ersten Messzone 12' ein weiterer Messabschnitt 6 vorgesehen, durch den die Spannungsmesselektrode 11' mit der Funktionsschicht 3 elektrisch verbunden ist.

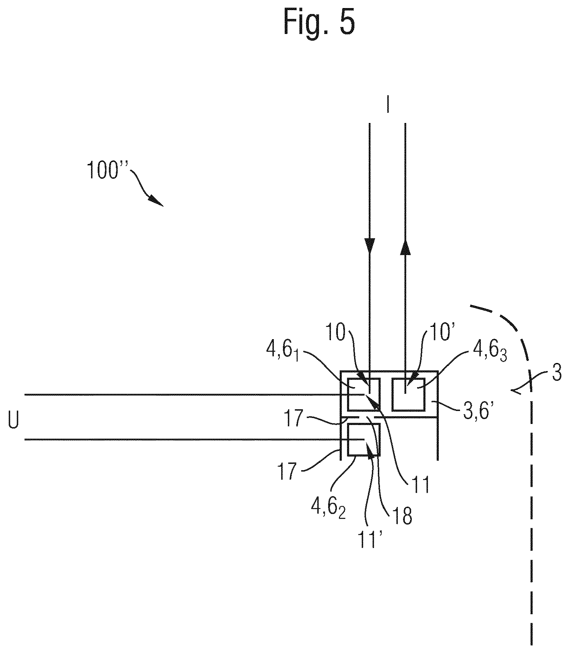

In Fig. 5 ist eine weitere alternative Messanordnung 100'' zur Messung des Kontaktwiderstands zwischen Funktions- und Elektrodenschicht 3, 4 veranschaulicht. Um unnötige Wiederholungen zu vermeiden, werden lediglich die Unterschiede zu der in den Figuren 2 und 3 veranschaulichten Messanordnung 100 erläutert und ansonsten wird auf die dort gemachten Ausführungen Bezug genommen.

Demnach umfasst die Messanordnung 100'' eine Elektrodenschicht 4 mit drei Messabschnitten 6₁, 6₂, 6₃. Die Funktionsschicht 3 ist nicht in verschiedene Abschnitte unterteilt. Die drei Messabschnitte 6₁, 6₂, 6₃ haben hier beispielsweise eine rechteckige, insbesondere quadratische Form mit einer jeweiligen Kontaktzone 5 gleicher Größe, wobei sich die Kontaktzone jeweils über den vollständigen Messabschnitt 6₁, 6₂, 6₃ erstreckt.

Um den Kontaktwiderstand der Kontaktzone 5 eines ersten Messabschnitts 6₁ zu bestimmen, kontaktiert die eine Stromelektrode 10 direkt den ersten Messabschnitt 6₁, die andere Stromelektrode 10' kontaktiert direkt den zweiten Messabschnitt 6₂. Die beiden Spannungsmesselektroden 11, 11' sind wiederum quer zur Stromrichtung angeordnet, wobei die eine Spannungsmesselektrode 11 direkt den ersten Messabschnitt 6₁ und die andere Spannungsmesselektrode 11' direkt einen dritten Messabschnitt 6₃ kontaktiert. Die Funktionsschicht 3 ist durch beispielsweise mittels eines Lasers eingearbeitete Einschnitte 17 unterteilt. Die Einschnitte 17 trennen den ersten Messabschnitt 6₁ und zweiten Messabschnitt 6₂ gemeinsam vom dritten Messabschnitt 6₃ ab, mit Ausnahme eines durch die Funktionsschicht 3 geformten Verbindungsstegs 18, welcher den ersten Messabschnitt 6₁ und den dritten Messabschnitt 6₃ elektrisch miteinander verbindet. Der Verbindungssteg 18 erstreckt sich quer zur Stromrichtung und ist in fluchtender Verlängerung zur Kontaktzone 5 des ersten Messabschnitts 6₁ angeordnet. Die Abmessung bzw. Breite des Verbindungsstegs 18 in Stromrichtung ist kleiner ist als die entsprechende Abmessung bzw. Breite der Kontaktzone 5 des ersten Messabschnitts 6₁. Der dritte Messabschnitts 6₃ ist quer zur Stromrichtung in fluchtender Verlängerung zur Kontaktzone 5 des ersten Messabschnitts 6₁ angeordnet.

Auch die Messanordnung 100'' von Fig. 5 schafft eine definierte elektrische Messumgebung zur Messung der Potentialdifferenz an der Kontaktzone 5, die in der praktischen Anwendung einfach und kostengünstig realisiert werden kann.

Die Erfindung stellt Messanordnungen und Verfahren zur Bestimmung des Kontaktwiderstands elektrisch leitfähiger Schichten zur Verfügung, durch welche der Kontaktwiderstand einfach und zuverlässig ermittelt werden kann. In besonders vorteilhafter Weise kann der Kontaktwiderstand auch während des Herstellungsprozesses von Flächenkörpern der in Rede stehenden Art bestimmt werden, so dass im Fall einer schlechten Kontaktqualität frühzeitig entsprechende Maßnahmen ergriffen werden können, um Zeit und Kosten in der Serienfertigung einzusparen. Die Anordnung der Strom- und Spannungspfade ist geometrisch so festgelegt, dass eine möglichst gute Aussage über den Übergangs- bzw. Kontaktwiderstand getroffen werden kann. Beispielsweise sind zusätzliche Stromkontaktierungsstellen (z.B. mehrere Stromelektroden, welche die erste Schicht kontaktieren) nicht möglich, weil dies die sorgfältig ausgewählten geometrischen Bedingungen nicht machen würde. Die Kontaktzone wird beispielsweise durch Aufdrucken einer Silberdruckpaste ausgebildet, wobei generell der elektrische Widerstand der Elektrodenschicht die limitierende Größe bei der Messung des Kontaktwiderstands ist. Daher liegen die Messwerte relativ nah beieinander, so dass sie genauer zu messen sind. Dies würde nicht gelten, wenn der Kontaktwiderstand sehr klein, insbesondere nahe 0 Ohm, ist. Ein weiterer Vorteil der erfindungsgemäßen Anordnungen ergibt sich aus der Tatsache, dass diese bei einer schlechten Kontaktierung definiert durchbrennen, wobei diese Eigenschaft ein Aussortierungsmerkmal des Gesamtproduktes (Flächenkörper) in der Produktion sein kann.

### Bezugszeichenliste

1 Flächenkörper
2 Substrat
3 Funktionsschicht
4 Elektrodenschicht
5 Kontaktzone
6, 6', 6₁, 6₂, 6₃ Messabschnitt
7, 7' Funktionsabschnitt
8, 8' erster Teil
9, 9' zweiter Teil
10, 10' Stromelektrode
11, 11' Spannungsmesselektrode
12, 12' Messzone
13, 13', 13'' Bereich
14 Stromquelle
15 Spannungsmessgerät
16 Schichtenaufbau
17 Einschnitt
18 Verbindungssteg
100, 100', 100'' Messanordnung

## Patentansprüche

1. Anordnung (100) zur Bestimmung des Kontaktwiderstands elektrisch leitfähiger Schichten (3, 4), welche umfasst:
- einen Schichtenaufbau (16), bei dem eine elektrisch leitfähige erste Schicht (6) auf eine elektrisch leitfähige zweite Schicht (6') aufgebracht ist, wobei die erste Schicht (6) die zweite Schicht (6') in einer Kontaktzone (5) kontaktiert;
- zwei Stromelektroden (10, 10'), wobei die eine Stromelektrode (10) mit der ersten Schicht (6) und die andere Stromelektrode (10') mit der zweiten Schicht (6') elektrisch verbunden ist;
- zwei Spannungsmesselektroden (11, 11'), wobei die eine Spannungsmesselektrode (11) in einer ersten Messzone (12) mit der ersten Schicht (6) verbunden ist, wobei sich die erste Messzone (12) aus einem der Kontaktzone (5) gegenüberliegenden Bereich (13) der ersten Schicht (4) und einem diesen Bereich (13) quer zu einer geraden Verbindungslinie zwischen den beiden Stromelektroden fluchtend verlängernden Bereich (13'') der ersten Schicht (6) ergibt, und wobei die andere Spannungsmesselektrode (11') in einer zweiten Messzone (12') mit der zweiten Schicht (6') verbunden ist, wobei sich die zweite Messzone (12') aus einem die Kontaktzone (5) quer zu einer geraden Verbindungslinie zwischen den beiden Stromelektroden fluchtend verlängernden Bereich (13') der zweiten Schicht (6') ergibt.

2. Anordnung (100) nach Anspruch 1, bei welcher die beiden Schichten (6, 6') jeweils einen ersten Teil (8, 8') und einen damit verbundenen zweiten Teil (9, 9') umfassen, wobei die Kontaktzone (5) ausschließlich von den beiden ersten Teilen (8, 8') gebildet wird und die beiden zweiten Teile jeweils (9, 9') quer zu einer geraden Verbindungslinie zwischen den beiden Stromelektroden in fluchtender Verlängerung zur Kontaktzone (5) angeordnet sind.

3. Anordnung (100) nach Anspruch 2, bei welcher die beiden zweiten Teile (9, 9') auf einander gegenüberliegenden Seiten der Kontaktzone (5) angeordnet sind.

4. Anordnung (100') zur Bestimmung des Kontaktwiderstands elektrisch leitfähiger Schichten (3, 4), welche umfasst:
- einen Schichtenaufbau (16), bei dem eine elektrisch leitfähige erste Schicht (4) auf eine elektrisch leitfähige zweite Schicht (3) aufgebracht ist, wobei die erste Schicht (4) wenigstens zwei voneinander getrennte Schichtabschnitte (6, 7) aufweist, wobei ein erster Schichtabschnitt (6) die zweite Schicht (3) in einer Kontaktzone (5) kontaktiert;
- zwei Stromelektroden (10, 10'), wobei die eine Stromelektrode (10) mit dem ersten Schichtabschnitt (6) und die andere Stromelektrode (10') mit dem zweiten Schichtabschnitt (7) elektrisch verbunden ist;
- zwei Spannungsmesselektroden (11, 11'), wobei die eine Spannungsmesselektrode (11) in einer ersten Messzone (12) mit der ersten Schicht (6) verbunden ist, wobei sich die erste Messzone (12) aus einem der Kontaktzone (5) gegenüberliegenden Bereich (13) des ersten Schichtabschnitts (6) ergibt, und wobei die andere Spannungsmesselektrode (11') in einer zweiten Messzone (12') mit der zweiten Schicht (3) verbunden ist, wobei sich die zweite Messzone (12') aus einem die Kontaktzone (5) quer zu einer geraden Verbindungslinie zwischen den beiden Stromelektroden fluchtend verlängernden Bereich (13') der zweiten Schicht (3) ergibt.

5. Anordnung (100'') nach Anspruch 4, bei welcher die erste Schicht (4) wenigstens drei voneinander getrennte Schichtabschnitte (6₁, 6₂, 6₃) aufweist, wobei ein erster Schichtabschnitt (6₁) die zweite Schicht (3) in der Kontaktzone (5) kontaktiert, wobei die eine Stromelektrode (10) und die eine Spannungsmesselektrode (11) mit dem ersten Schichtabschnitt (6₁), die andere Stromelektrode (10') mit einem zweiten Schichtabschnitt (6₂) und die andere Spannungsmesselektrode (11') mit einem dritten Schichtabschnitt (6₃) elektrisch verbunden sind.

6. Anordnung (100'') nach Anspruch 5, bei welcher die zweite Schicht (3) so unterteilt ist, dass der erste Schichtabschnitt (6₁) und der dritte Schichtabschnitt (6₃) durch einen quer zu einer geraden Verbindungslinie zwischen den beiden Stromelektroden sich erstreckenden Verbindungssteg (18) der zweiten Schicht (3) elektrisch miteinander verbunden sind, wobei der Verbindungssteg (18) in fluchtender Verlängerung zur Kontaktzone (5) angeordnet ist.

7. Anordnung (100'') nach Anspruch 6, bei welcher eine Abmessung des Verbindungsstegs (18) in Stromrichtung gleich zu oder kleiner ist als eine entsprechende Abmessung der Kontaktzone (5).

8. Anordnung (100'') nach einem der Ansprüche 5 bis 7, bei welcher der dritte Schichtabschnitt (6₃) quer zu einer geraden Verbindungslinie zwischen den beiden Stromelektroden in fluchtender Verlängerung zur Kontaktzone (5) angeordnet ist.

9. Verfahren zur Bestimmung des Kontaktwiderstands elektrisch leitfähiger Schichten (3, 4), welches die folgenden Schritte umfasst:
- Bereitstellen eines Schichtenaufbaus (16), bei dem eine leitfähige erste Schicht (6) auf eine leitfähige zweite Schicht (6') aufgebracht ist, wobei die erste Schicht (6) die zweite Schicht (6') in einer Kontaktzone (5) kontaktiert;
- Erzeugen eines elektrischen Stroms durch die Kontaktzone (5), wobei eine Stromelektrode (10) mit der ersten Schicht (6) und eine andere Stromelektrode (10') mit der zweiten Schicht (6') elektrisch verbunden werden;
- Messen einer Potentialdifferenz an der Kontaktzone (5), wobei eine Spannungsmesselektrode (11) in einer ersten Messzone (12) mit der ersten Schicht (6) verbunden wird, wobei sich die erste Messzone (12) aus einem der Kontaktzone (5) gegenüberliegenden Bereich (13) der ersten Schicht (6) und einem diesen Bereich (13) quer zu einer geraden Verbindungslinie zwischen den beiden Stromelektroden fluchtend verlängernden Bereich (13'') der ersten Schicht (6) ergibt, und wobei eine andere Spannungsmesselektrode (11') in einer zweiten Messzone (12') mit der zweiten Schicht (6') verbunden wird, wobei sich die zweite Messzone (12') aus einem die Kontaktzone (5) quer zu einer geraden Verbindungslinie zwischen den beiden Stromelektroden fluchtend verlängernden Bereich (13) der zweiten Schicht (6') ergibt.

10. Verfahren zur Bestimmung des Kontaktwiderstands elektrisch leitfähiger Schichten (3, 4), welches die folgenden Schritte umfasst:
- Bereitstellen eines Schichtenaufbaus (16), bei dem eine leitfähige erste Schicht (4) auf eine leitfähige zweite Schicht (3) aufgebracht ist, wobei die erste Schicht (4) wenigstens zwei voneinander getrennte Schichtabschnitte (6, 7) aufweist, wobei ein erster Schichtabschnitt (6) die zweite Schicht (3) in einer Kontaktzone (5) kontaktiert;
- Erzeugen eines elektrischen Stroms durch die Kontaktzone (5), wobei eine Stromelektrode (10) mit dem ersten Schichtabschnitt (6) und eine andere Stromelektrode (10') mit dem zweiten Schichtabschnitt (7) elektrisch verbunden wird;
- Messen einer Potentialdifferenz an der Kontaktzone (5), wobei eine Spannungsmesselektrode (11) in einer ersten Messzone (12) mit dem ersten Schichtabschnitt (6) verbunden wird, wobei sich die erste Messzone (12) aus einem der Kontaktzone (5) gegenüberliegenden Bereich (13) des ersten Schichtabschnitts (6) ergibt, und wobei eine andere Spannungsmesselektrode (11') in einer zweiten Messzone (12') mit dem zweiten Schichtabschnitt (7) verbunden wird, wobei sich die zweite Messzone (12') aus einem die Kontaktzone (5) quer zu einer geraden Verbindungslinie zwischen den beiden Stromelektroden fluchtend verlängernden Bereich (13') der zweiten Schicht (3) ergibt.

11. Verwendung einer Anordnung (100; 100'') nach einem der Ansprüche 1 bis 3 oder nach einem der Ansprüche 4 bis 8 zur Bestimmung des Kontaktwiderstands wenigstens einer auf eine Funktionsschicht aufgebrachten Elektrodenschicht eines Flächenkörpers (1).

12. Verwendung eines Verfahrens nach einem der Ansprüche 9 oder 10 zur Bestimmung des Kontaktwiderstands wenigstens einer auf eine Funktionsschicht aufgebrachten Elektrodenschicht eines Flächenkörpers (1).

## Claims

1. Arrangement (100) for determining the contact resistance of electrically conductive layers (3, 4), which comprises:
- a layer structure (16), in which an electrically conductive first layer (6) is applied on an electrically conductive second layer (6'), wherein the first layer (6) contacts the second layer (6') in a contact zone (5) ;
- two current electrodes (10, 10'), wherein one current electrode (10) is electrically connected to the first layer (6) and the other current electrode (10') is electrically connected to the second layer (6');
- two voltage measurement electrodes (11, 11'), wherein one voltage measurement electrode (11) is connected, in a first measurement zone (12), to the first layer (6), wherein the first measurement zone (12) results from a region (13) of the first layer (4) opposite the contact zone (5) and a region (13'') of the first layer (6) extending this region (13) in alignment transversely to a straight connecting line between the two current electrodes, and wherein the other voltage measurement electrode (11') is connected, in a second measurement zone (12'), to the second layer (6'), wherein the second measurement zone (12') results from a region (13') of the second layer (6') extending the contact zone (5) in alignment transversely to a straight connecting line between the two current electrodes.

2. Arrangement (100) according to claim 1, wherein the two layers (6, 6') comprise in each case a first part (8, 8') and a second part (9, 9') connected thereto, wherein the contact zone (5) is formed exclusively by the two first parts (8, 8') and the two second parts (9, 9') are arranged in each case transversely to a straight connecting line between the two current electrodes in aligned extension of the contact zone (5).

3. Arrangement (100) according to claim 2, wherein the two second parts (9, 9') are arranged on sides of the contact zone (5) opposite one another.

4. Arrangement (100') for determining the contact resistance of electrically conductive layers (3, 4), which comprises:
- a layer structure (16), in which an electrically conductive first layer (4) is applied on an electrically conductive second layer (3), wherein the first layer (4) has at least two layer sections that are separated from one another (6, 7), wherein a first layer section (6) contacts the second layer (3) in a contact zone (5);
- two current electrodes (10, 10'), wherein one current electrode (10) is electrically connected to the first layer section (6) and the other current electrode (10') is electrically connected to the second layer section (7);
- two voltage measurement electrodes (11, 11'), wherein one voltage measurement electrode (11) is connected, in a first measurement zone (12), to the first layer (6), wherein the first measurement zone (12) results from a region (13) of the first layer section (6) opposite the contact zone (5), and wherein the other voltage measurement electrode (11') is connected, in a second measurement zone (12'), to the second layer (3), wherein the second measurement zone (12') results from a region (13') of the second layer (3) extending the contact zone (5) in alignment transversely to a straight connecting line between the two current electrodes.

5. Arrangement (100'') according to claim 4, wherein the first layer (4) has at least three layer sections that are separated from one another (6₁, 6₂, 6₃), wherein a first layer section (6₁) contacts the second layer (3) in the contact zone (5), wherein one current electrode (10) and one voltage measurement electrode (11) are electrically connected to the first layer section (6₁), the other current electrode (10') is electrically connected to a second layer section (6₂), and the other voltage measurement electrode (11') is electrically connected to a third layer section (6₃).

6. Arrangement (100'') according to claim 5, wherein the second layer (3) is divided such that the first layer section (6₁) and the third layer section (6₃) are electrically connected to one another via a connection web (18) of the second layer (3) running transversely to a straight connecting line between the two current electrodes, wherein the connection web (18) is arranged in aligned extension of the contact zone (5).

7. Arrangement (100'') according to claim 6, wherein a dimension of the connection web (18) in the flow direction is equal to or less than a corresponding dimension of the contact zone (5).

8. Arrangement (100'') according to one of claims 5 through 7, wherein the third layer section (6₃) is arranged transversely to a straight connecting line between the two current electrodes in aligned extension of the contact zone (5).

9. Method for determining the contact resistance of electrically conductive layers (3, 4), which comprises the following steps:
- Preparation of a layer structure (16), in which a conductive first layer (6) is applied on a conductive second layer (6'), wherein the first layer (6) contacts the second layer (6') in a contact zone (5);
- Creation of an electrical current through the contact zone (5), wherein one current electrode (10) is electrically connected to the first layer (6) and another current electrode (10') is electrically connected to the second layer (6');
- Measurement of a difference in potential on the contact zone (5), wherein a voltage measurement electrode (11) is connected, in a first measurement zone (12), to the first layer (6), wherein the first measurement zone (12) results from a region (13) of the first layer (6) opposite the contact zone (5) and a region (13'') of the first layer (6) extending this region (13) in alignment transversely to a straight connecting line between the two current electrodes, and wherein another voltage measurement electrode (11') is connected, in a second measurement zone (12'), to the second layer (6'), wherein the second measurement zone (12') results from a region (13) of the second layer (6') extending the contact zone (5) in alignment transversely to a straight connecting line between the two current electrodes.

10. Method for determining the contact resistance of electrically conductive layers (3, 4), which comprises the following steps:
- Preparation of a layer structure (16), in which a conductive first layer (4) is applied on a conductive second layer (3), wherein the first layer (4) has at least two layer sections that are separated from one another (6, 7), wherein a first layer section (6) contacts the second layer (3) in a contact zone (5);
- Creation of an electrical current through the contact zone (5), wherein one current electrode (10) is electrically connected to the first layer section (6) and another current electrode (10') is electrically connected to the second layer section (7);
- Measurement of a difference in potential on the contact zone (5), wherein a voltage measurement electrode (11) is connected, in a first measurement zone (12), to the first layer section (6), wherein the first measurement zone (12) results from a region (13) of the first layer section (6) opposite the contact zone (5), and wherein another voltage measurement electrode (11') is connected, in a second measurement zone (12'), to the second layer section (7), wherein the second measurement zone (12') results from a region (13') of the second layer (3) extending the contact zone (5) in alignment transversely to a straight connecting line between the two current electrodes.

11. Use of an arrangement (100; 100'') according to one of claims 1 through 3 or according to one of claims 4 through 8 for determining the contact resistance of at least one electrode layer of a flat body (1) applied on a functional layer.

12. Use of a method according to one of claims 9 or 10 for determining the contact resistance of at least one electrode layer of a flat body (1) applied on a functional layer.

## Revendications

1. Arrangement (100) pour la détermination de la résistance de contact de couches électriquement conductrices (3, 4), qui comprend :
- une structure de couches (16), dans laquelle une première couche électriquement conductrice (6) est posée sur une deuxième couche électriquement conductrice (6') où la première couche (6) établit le contact avec la deuxième couche (6') dans une zone de contact (5);
- deux électrodes de courant (10, 10'), où l'une des électrodes de courant (10) est reliée électriquement avec la première couche (6) et l'autre électrode de courant (10') avec la deuxième couche (6').
- deux électrodes de mesure de tension (11, 11'), où l'une des électrodes de mesure de tension (11) est reliée dans une première zone de mesure (12) avec la première couche (6), où la première zone de mesure (12) résulte d'une région (13) de la première couche (4) en face de la zone de contact (5), et d'une région (13'') de la première couche (6) en extension de cette zone (13) alignée perpendiculaire à une ligne droite de liaison entre les deux électrodes de courant, et où l'autre électrode de mesure de tension (11') est reliée dans une deuxième zone de mesure (12') avec la deuxième couche (6'), où la deuxième zone de mesure (12') résulte d'une région de la deuxième couche (6') en extension alignée de la zone de contact (5) perpendiculaire à une ligne droite de liaison entre les deux électrodes de courant (13').

2. Arrangement (100) selon la revendication 1, dans lequel les deux couches (6, 6') comprennent respectivement une première partie (8, 8') et une deuxième partie qui y est associée (9, 9'), où la zone de contact (5) est formée uniquement par les deux premières parties (8, 8') et où les deux deuxième parties (9, 9') sont disposées en extension par rapport à la zone de contact (5) perpendiculaires à une ligne droite de liaison entre les deux électrodes de courant.

3. Arrangement (100) selon la revendication 2, dans lequel les deux deuxième parties (9, 9') sont disposées sur des faces opposées de la zone de contact (5).

4. Arrangement (100') pour la détermination de la résistance de contact des couches conductrices (3, 4), qui comprend :
- une structure de couches (16'), dans laquelle une première couche électriquement conductrice (4) est posée sur une deuxième couche électriquement conductrice (3) où la première couche (4) présente au moins deux sections de couche (6, 7) séparées les unes des autres, où une première section de couche (6) établit le contact avec la deuxième couche (3) dans une zone de contact (5) ;
- deux électrodes de courant (10, 10'), où l'une des électrodes de courant (10) est reliée électriquement avec la première section de couche (6) et l'autre électrode de courant (10') avec la deuxième section de couche (7);
- deux électrodes de mesure de tension (11, 11'), où l'une des électrodes de mesure de tension (11) est reliée dans une première zone de mesure (12) avec la première couche (6), où la première zone de mesure (12) résulte d'une région (13) de la première section de couche (6) se trouvant en face de la zone de contact (5), et l'autre électrode de mesure de tension (11') est reliée dans une deuxième zone de mesure (12') avec la deuxième couche (3), où la deuxième zone de mesure (12') résulte d'une région de la deuxième couche (3) en extension de la zone de contact (5) alignée perpendiculaire à une ligne droite de liaison entre les deux électrodes de courant (13').

5. Arrangement (100'') selon la revendication 4, où la première couche (4) présente au moins trois sections de couche séparées les unes des autres (61, 62, 63), où une première section de couche (61) établit le contact avec la deuxième couche (3) dans la zone de contact (5), où sont reliées électriquement l'une des électrodes de courant (10) et l'une des électrodes de mesure de courant (11) avec la première section de couche (61), l'autre électrode de courant (10') avec une deuxième section de couche (62) et l'autre électrode de mesure de courant (11') avec une troisième section de couche (63).

6. Arrangement (100'') selon la revendication 5, où la deuxième couche (3) est subdivisée de telle façon que la première section de couche (61) et la troisième section de couche (63) sont électriquement reliées par une barrette de liaison (18) s'étendant perpendiculaire à une ligne droite de liaison entre les deux électrodes de courant de la deuxième couche (3), où la barrette de raccordement (18) est disposée en extension par rapport à la zone de contact (5).

7. Arrangement (100') selon la revendication 6, dans lequel une dimension de la barrette de raccordement (18) dans le sens du courant est égale ou inférieure à une dimension correspondante de la zone de contact (5).

8. Arrangement (100') selon l'une des revendications 5 à 7, dans lequel la troisième section de couche (63) est disposée perpendiculaire à une ligne droite de liaison entre les deux électrodes de courant en extension alignée à la zone de contact (5).

9. Procédure pour la détermination de la résistance de contact de couches électriquement conductrices (3, 4), qui comprend les étapes suivantes :
- fourniture d'une construction de couches (16), dans laquelle une première couche conductrice (6) est posée sur une deuxième couche conductrice (6'), où la première couche (6) établit le contact avec la deuxième couche (6') dans une zone de contact (5) ;
- génération d'un courant électrique à travers la zone de contact (5), où sont reliées électriquement une électrode de courant (10) avec la première couche (6) et une autre électrode de courant (10') avec la deuxième couche (6') ;
- mesure d'une différence de potentiel dans la zone de contact (5), où une électrode de mesure de tension (11) est reliée avec la première couche (6) dans une première zone de mesure (12), où la première zone de mesure (12) résulte d'une région (13) de la première couche (6) en face de la zone de contact (5) et d'une région (13'') de la première couche (6) en extension de cette zone (13) alignée perpendiculaire à une ligne droite de liaison entre les deux électrodes de courant, et où une autre électrode de mesure de tension (11') est reliée dans une deuxième zone de mesure (12') avec la deuxième couche (6'), où la deuxième zone de mesure (12') résulte d'une région (13) de la deuxième couche (6') en extension alignée de la zone de contact (5) perpendiculaire à une ligne droite de liaison entre les deux électrodes de courant.

10. Procédure pour la détermination de la résistance de contact de couches électriquement conductrices (3, 4), qui comprend les étapes suivantes :
- fourniture d'une construction de couches (16), dans laquelle une première couche conductrice (4) est posée sur une deuxième couche conductrice (3), où la première couche (4) présente au moins deux sections de couche (6, 7) séparées les unes des autres, où une première section la couche (6) établit le contact avec la deuxième couche (3) dans une zone de contact (5) :
- génération d'un courant électrique à travers la zone de contact (5), où sont reliées électriquement une électrode de courant (10) avec la première couche (6) et une autre électrode de courant (10') avec la deuxième couche (6')
- mesure d'une différence de potentiel dans la zone de contact (5), où une électrode de mesure de tension (11) est reliée avec la première section de couche (6), où la première zone de mesure (12) résulte d'une région (13) de la première section de couche (6) en face de la zone de contact (5) et où une autre électrode de mesure de tension (11') dans une deuxième zone de mesure (12') est reliée avec une deuxième section de couche (7), où la deuxième zone de mesure (12') résulte d'une région (13') de la deuxième couche (3) en extension alignée de la zone de contact (5) perpendiculaire à une ligne droite de liaison entre les deux électrodes de courant.

11. Utilisation d'un arrangement (100, 100'') selon l'une des revendications 1 à 3, ou selon l'une des revendications 4 à 8 pour la détermination de la résistance de contact de couche d'au moins une électrode posée sur une couche fonctionnelle d'une feuille (1).

12. Utilisation d'une procédure selon l'une des revendications 9 ou 10 pour la détermination de la résistance de contact d'au moins une la couche au moins une électrode posée sur une couche fonctionnelle d'une feuille (1).
